(19)

Europäisches
Patentamt
European
Patent Office
Office européen
des brevets

(11) **EP 4 636 422 A1**

(12) **EUROPEAN PATENT APPLICATION**
published in accordance with Art. 153(4) EPC

(43) Date of publication:
 **22.10.2025 Bulletin 2025/43**

(21) Application number: **24913778.7**

(22) Date of filing: **11.10.2024**

(51) International Patent Classification (IPC):
 *G01R 31/392* (2019.01)   *G01R 31/396* (2019.01)
 *G01R 31/382* (2019.01)   *G01R 31/367* (2019.01)
 *G01R 31/36* (2020.01)   *G01R 19/165* (2006.01)
 *G01R 19/00* (2006.01)   *H01M 10/48* (2006.01)

(52) Cooperative Patent Classification (CPC):
 **G01R 31/396; G01R 31/3835; G01R 31/392**

(86) International application number:
 **PCT/KR2024/096347**

(87) International publication number:
 **WO 2025/143974 (03.07.2025 Gazette 2025/27)**

(84) Designated Contracting States:
 **AL AT BE BG CH CY CZ DE DK EE ES FI FR GB
 GR HR HU IE IS IT LI LT LU LV MC ME MK MT NL
 NO PL PT RO RS SE SI SK SM TR**
 Designated Extension States:
 **BA**
 Designated Validation States:
 **GE KH MA MD TN**

(30) Priority: **26.12.2023 KR 20230191785
 24.09.2024 KR 20240129279**

(71) Applicant: **LG Energy Solution, Ltd.
 Seoul 07335 (KR)**

(72) Inventors:
 • **KIM, Tae-Hyeon
  Daejeon 34122 (KR)**
 • **KIM, Young-Deok
  Daejeon 34122 (KR)**
 • **KIM, Ji-Yeon
  Daejeon 34122 (KR)**
 • **CHOI, Hyun-Jun
  Daejeon 34122 (KR)**

(74) Representative: **Goddar, Heinz J.
 Boehmert & Boehmert
 Anwaltspartnerschaft mbB
 Pettenkoferstrasse 22
 80336 München (DE)**

(54) **BATTERY DIAGNOSIS APPARATUS, BATTERY PACK, BATTERY SYSTEM AND BATTERY DIAGNOSIS METHOD**

(57)   A battery diagnostic apparatus includes: a data acquisition unit configured to acquire capacity-voltage relationship data of a battery cell; and a processor configured to generate a voltage profile and a differential voltage profile of the battery based on the capacity-voltage relationship data. The processor is configured to extract a first interest profile from the voltage profile based on a characteristic point of the differential voltage profile, determine a characteristic slope associated with the first interest profile, and diagnose a degradation state of the battery cell based on the characteristic slope.

FIG. 1

EP 4 636 422 A1

**Description**

TECHNICAL FIELD

The present disclosure relates to a technology for diagnosing the degradation state of a battery cell.

This application is based on and claims priority from Korean Patent Applications Nos. 10-2023-0191785, filed on December 26, 2023 and 10-2024-0129279, filed on September 24, 2024 with the Korean Intellectual Property Office, the disclosure of which is incorporated herein in its entirety by reference.

BACKGROUND ART

Recently, as the demand for portable electronic products such as laptops, video cameras, and portable phones has rapidly increased, and as the development of electric vehicles, energy storage batteries, robots, and satellites has begun in earnest, research on repeatedly chargeable/dischargeable high-performance batteries is actively underway. Meanwhile, along with the widespread use of these high-performance batteries, research is also actively being conducted to efficiently manage these high-performance batteries.

Currently commercialized batteries include, for example, nickel cadmium batteries, nickel hydrogen batteries, nickel zinc batteries, and lithium batteries. Among these, the lithium batteries are in the spotlight because of their advantages including minimal, if any, memory effect compared to the nickel-based batteries, free charging and discharging, very low self-discharging rate, and high energy density.

DISCLOSURE

Technical Problem

The present disclosure provides a battery diagnostic apparatus and a battery diagnostic method for accurately estimating at least one degradation parameter related to the degradation state of a battery cell without disassembling the battery cell.

Other aspects and advantages of the present disclosure can be understood from the following description, and will be more clearly understood by practicing the present disclosure. In addition, it will be readily apparent that the aspects and advantages of the present disclosure can be implemented by the features set forth in the claims and combinations thereof.

Technical Solution

According to an aspect of the present disclosure, a battery diagnostic apparatus includes: data acquisition circuitry configured to acquire capacity-voltage relationship data of a battery cell; and a processor configured to generate a voltage profile and a differential voltage profile of the battery based on the capacity-voltage relationship data. The processor is configured to extract a first interest profile from the voltage profile based on a characteristic point of the differential voltage profile. The processor is configured to determine a characteristic slope associated with the first interest profile. The processor is configured to diagnose a degradation state of the battery cell based on the characteristic slope.

The processor may be configured to determine a data point having a minimum differential voltage value within a target capacity range as the characteristic point of the differential voltage profile.

The processor may be configured to determine an interest capacity range based on a capacity value of the characteristic point of the differential voltage profile, the processor may be configured to determine a portion of the voltage profile corresponding to the interest capacity range as the first interest profile.

The processor may be configured to normalize a capacity-voltage domain of the first interest profile to match a reference capacity-voltage domain to determine a second interest profile. The processor may be configured to determine the characteristic slope to be equal to a slope of a tangent at a characteristic point of the second interest profile.

The processor may be configured to determine multiple comparison values respectively associated with multiple data points of the second interest profile. The processor may be configured to determine any one of the multiple data points associated with a minimum of the multiple comparison values as the characteristic point of the second interest profile.

The processor may be configured to divide the second interest profile into a first sub-profile and a second sub-profile based on a capacity value of each of the multiple data points. The processor may be configured to determine the comparison value of each of the multiple data points to be equal to a sum of a first error value based on an average voltage value of the first sub-profile and a second error value based on an average voltage value of the second sub-profile.

The processor may be configured to determine a first degradation parameter representing a capacity reduction ratio caused by positive electrode degradation of the battery cell using the characteristic slope as an input variable for a linear regression model.

The processor may be configured to determine a second degradation parameter representing a capacity reduction ratio caused by available lithium loss in the battery cell based on a total capacity reduction ratio of the battery cell and the first degradation parameter.

The capacity-voltage relationship data may include a capacity time series and a voltage time series of the battery cell during charging or discharging of the battery cell.

According to another aspect of the present disclosure, a battery pack includes the battery diagnosis apparatus.

According to another aspect of the present disclosure, a battery system includes the battery diagnosis apparatus.

According to still another aspect of the present disclosure, a method for diagnosing a battery pack may include: acquiring capacity-voltage relationship data of a battery cell; generating a voltage profile and a differential voltage profile of the battery cell based on the capacity-voltage relationship data; extracting a first interest profile from the voltage profile based on a characteristic point of the differential voltage profile; determining a characteristic slope associated with the first interest profile; and diagnosing a degradation state of the battery cell based on the characteristic slope.

The extracting the first interest profile from the voltage profile may include: determining an interest capacity range based on a capacity value of the characteristic point of the differential voltage profile; and determining a portion of the voltage profile corresponding to the interest capacity range as the first interest profile.

The determining the characteristic slope associated with the first interest profile may further include: normalizing a capacity-voltage domain of the first interest profile to match a reference capacity-voltage domain to determine a second interest profile; and determining the characteristic slope to be equal to a slope of a tangent at a characteristic point of the second interest profile.

The determining the characteristic slope associated with the first interest profile may further include: determining multiple comparison values respectively associated with multiple data points of the second interest profile; and determining any one of the multiple data points associated with a minimum of the multiple comparison values as the characteristic point of the second interest profile.

According to yet another aspect of the present disclosure, a non-transitory computer-readable recording medium stores a computer program. The program includes instructions that, when executed by a processor, cause the processor to perform operations including: acquiring capacity-voltage relationship data of a battery cell; generating a voltage profile and a differential voltage profile of the battery cell based on the capacity-voltage relationship data; extracting a first interest profile from the voltage profile based on a characteristic point of the differential voltage profile; determining a characteristic slope associated with the first interest profile; and diagnosing a degradation state of the battery cell based on the characteristic slope.

The extracting the first interest profile from the voltage profile may include: determining an interest capacity range based on a capacity value of the characteristic point of the differential voltage profile; and determining a portion of the voltage profile corresponding to the interest capacity range as the first interest profile.

The determining the characteristic slope associated with the first interest profile may further include: normalizing a capacity-voltage domain of the first interest profile to match a reference capacity-voltage domain to determine a second interest profile; and determining the characteristic slope to be equal to a slope of a tangent at a characteristic point of the second interest profile.

The determining the characteristic slope associated with the first interest profile may further include: determining multiple comparison values respectively associated with multiple data points of the second interest profile; and determining any one of the multiple data points associated with a minimum of the multiple comparison values as the characteristic point of the second interest profile.

Advantageous Effects

According to at least one of the embodiments of the present disclosure, at least one degradation parameter related to the degradation state of a battery cell may be accurately estimated without disassembling the battery cell. For example, the present disclosure may enable a nondestructive diagnosis of the positive electrode degradation state of a battery cell.

According to at least one of the embodiments of the present disclosure, by extracting a portion of the voltage profile (hereinafter, referred to as a "first interest profile") of a battery cell over a predetermined voltage range, in which the voltage characteristics of the positive electrode material dominate those of the negative electrode material, from the entire voltage profile (hereinafter, referred to as a "Q-V profile"), the degradation state of the positive electrode material in the battery cell (*e.g.,* the capacity degradation rate caused by positive electrode degradation) may be more accurately identified.

According to at least one of the embodiments of the present disclosure, by utilizing the relationship among the total capacity reduction ratio of a battery cell, the capacity reduction ratio caused by positive electrode degradation, and the capacity reduction ratio caused by lithium loss, the capacity reduction ratio caused by lithium loss may be easily determined from the total capacity reduction ratio and the capacity reduction ratio caused by the positive electrode degradation of the battery cell.

The effects of the present disclosure are not limited to those mentioned above, and other effects not mentioned above will be clearly understood by a person ordinarily skilled in the art from the description of the claims.

DESCRIPTION OF DRAWINGS

The following drawings attached hereto illustrate example embodiments of the present disclosure and, together with the detailed description to be described later, serve to further understand the technical idea of the present disclosure. Therefore, the present disclosure should not be construed as being limited to the matters illustrated in the drawings.

FIG. 1 is a view illustrating an example configuration of a battery system according to the present disclosure.
FIG. 2 is a graph illustrating an example of a Q-V profile of a battery cell.
FIG. 3 is a graph illustrating an example of a normalized Q-V profile obtained from the Q-V profile of FIG. 2.
FIG. 4 is a graph illustrating an example of a Q-dV/dQ profile associated with the normalized Q-V profile illustrated in FIG. 3.
FIG. 5 is a graph illustrating an example of a first interest profile.
FIG. 6 is a graph illustrating an example of a second interest profile.
FIG. 7 is a diagram referenced to explain the procedure of determining the characteristic slope of the second interest profile illustrated in FIG. 6.
FIG. 8 is an example diagram referenced to explain the relationship between a positive electrode degradation degree and the second interest profile.
FIGS. 9 to 11 are diagrams referenced to explain the characteristic slope of each of three second interest profiles illustrated in FIG. 8.
FIG. 12 is an example diagram referenced to explain the relationship between a positive electrode degradation degree and a characteristic slope.
FIG. 13 is a flowchart schematically illustrating a battery diagnosis method according to an embodiment of the present disclosure.
FIG. 14 is a flowchart illustrating subroutines that may be included in step S1330 of FIG. 13.
FIG. 15 is a flowchart illustrating subroutines that may be included in step S1410 of FIG. 14.
FIG. 16 is a flowchart illustrating subroutines that may be included in step S1330 of FIG. 13.
FIG. 17 is a flowchart illustrating subroutines that may be included in step S1620 of FIG. 16.

BEST MODE

Hereinafter, embodiments of the present disclosure will be described in detail with reference to the accompanying drawings. Prior to this, the terms or words used in the specification and claims should not be construed as limited to their ordinary or dictionary meanings, but should be construed as meanings and concepts consistent with the technical idea of the present disclosure based on the principle that an inventor may appropriately define the concepts of terms in order to explain their invention in the best way.

Accordingly, the embodiments described in this specification and the configurations illustrated in the drawings are merely example embodiments of the present disclosure, and do not represent all the technical ideas of the present disclosure. Therefore, it should be understood that, at the time of filing the present application, various equivalents and modifications that can replace these embodiments may exist.

Terms containing ordinal numbers, such as "first" and "second," are used to distinguish one from another among various components and are not intended to limit or define the components with such terms.

Throughout the specification, when a part is described as "including" a certain component, it means that, unless there is specific contrary wording, it does not exclude other components, but rather indicates that other components may be further included. In addition, a term, such as "unit," as described in the specification, refers to a unit that processes at least one function or operation and may be implemented in hardware, software, or a combination of hardware and software.

In addition, throughout the specification, when a part is described as being "connected" to another part, this includes not only the case where the parts are "directly connected," but also the case where the parts are "indirectly connected," with another element interposed therebetween.

Various degradation factors that reduce the capacity of lithium-ion batteries occur during repeated charge and discharge cycles. These degradations are influenced by a combination of multiple factors, and are understood to be primarily caused by, for example, the loss of lithium inventory (LLI), the loss of active material (LAM), and conductivity loss (CL).

The loss of lithium inventory is a degradation mode in which the solid electrolyte interface (SEI layer) gradually thickens on the surface of the negative electrode due to the decomposition reaction of electrolyte, leading to the depletion of lithium-ion sources as a result of consumption of the electrolyte. Meanwhile, when lithium is repeatedly inserted into and removed from the lattice of negative and positive electrode active materials, the structure of particles may degrade and the capacity may decrease. This degradation is classified as a degradation mode caused by the loss of active material. Furthermore, conductivity loss may occur when an electrode separates from the current collector or when, for example, cracks develop between electrode materials, leading to a decrease in ion and electron mobility. This degradation is classified as a degradation due to conductivity loss (CL).

Various techniques exist for monitoring the degradation of battery cells. For example, a differential voltage analysis method, which may also be referred to as "DVA," is based on time-series data of at least one battery parameter (*e.g.*, voltage, current, or capacity) that may be observed from outside the battery cell.

In DVA, the peaks that appear in a differential voltage curve (which may also be referred to as a "Q-dV/dQ profile") are considered as a key factor, and some types of battery cells exhibit a voltage plateau characteristic during charging or discharging where the rate of voltage change remains nearly zero. In the capacity range where the voltage plateau characteristic is expressed, the differential voltage is also close to zero, making it difficult to detect peaks from the Q-dV/dQ profile.

The present disclosure provides a method capable of accurately and easily diagnosing the degradation state of a battery cell without extracting peak information indicative of the degradation state from the Q-dV/dQ profile.

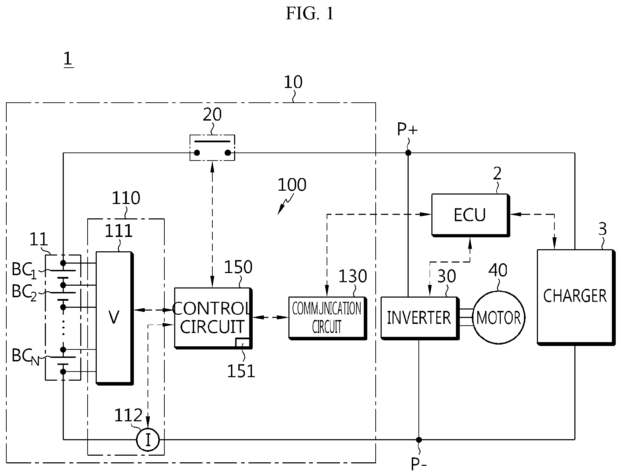

FIG. 1 is a view illustrating an example configuration of a battery system according to the present disclosure.

Referring to FIG. 1, a battery system 1 according to an embodiment of the present disclosure includes a system controller 2, a battery pack 10, an inverter 30, and an electric motor 40. The battery pack 10 includes a battery 11 and a relay 20 and may further include a battery diagnosis apparatus 100. The battery diagnosis apparatus 100 includes a sensing circuitry 110, a communication circuitry 130, and a processor 150 as a control circuitry. The sensing circuitry 110 may further include a voltage sensor 111 and a current sensor 112. The processor 150 may further include a memory 151.

The charge/discharge terminals (P+, P-) of the battery pack 10 may be electrically connected to a charger 3 via, for example, a charge cable. The charger 3 may either be included in the battery system 1 or be separately provided at a charge station. The system controller 2 (*e.g.*, an electronic control unit (ECU)) is configured to transmit a Key-ON signal to the battery diagnosis apparatus 100 in response to a start button (not illustrated) provided in the battery system 1 being switched to the ON position by a user. The system controller 2 is also configured to transmit a Key-OFF signal to the battery diagnosis apparatus 100 of the battery pack 10 in response to the start button being switched to the OFF position by the user. The charger 3 may communicate with the system controller 2 and supply charge power selected among constant power, constant current, and constant voltage through the charge/discharge terminals (P+, P-) of the battery pack 10.

The battery 11 includes at least one battery cell (BC). In FIG. 1, the battery 11 is illustrated to include multiple battery cells ($BC_1$ to $BC_N$, where N is a natural number of 2 or more) connected in series. The multiple battery cells $BC_1$ to $BC_N$ may be provided with identical electrochemical specifications. Hereinafter, when describing content common to the multiple battery cells $BC_1$ to $BC_N$, the symbol "BC" is assigned to the battery cells. The charger 3 may execute charge/discharge cycles necessary to diagnose the degradation state of the battery cells BC through collaboration with the inverter 30 having a discharge function.

The battery cells BC are the subject of diagnosis by the battery diagnosis apparatus 100. The type of battery cells BC is not particularly limited, as long as they are electrochemical devices capable of repetitive charging and discharging. According to an embodiment, the battery cells BC may be lithium iron phosphate ($LiFePO_4$ or LFP) battery cells that have a voltage plateau characteristic. The voltage plateau characteristic refers to a characteristic in which the voltage change rate is maintained below a predetermined threshold across at least one capacity range (or SOC range). The lithium iron phosphate battery cells may also be referred to as "$LiFePO_4$ battery cells," "LFP battery cells," or simply "LFP cells." Hereinafter, it is assumed that the battery cells BC are LFP battery cells that include LFP and graphite as the positive electrode material and the negative electrode material, respectively.

The relay 20 is electrically connected in series with the battery 11 via a power path interconnecting the battery 11 and the inverter 30. In FIG. 1, the relay 20 is illustrated as being connected between the positive terminal and the charge/discharge terminal P+ of the battery 11. The relay 20 is ON/OFF-controlled in response to a switching signal from the battery diagnosis system 100. The relay 20 may be a mechanical contactor that is turned ON and OFF by the magnetic force of a coil, or a semiconductor switch such as a metal oxide semiconductor field effect transistor (MOSFET).

The inverter 30 is configured to convert the direct current (DC) from the battery 11 included in the battery pack 10 into alternating current (AC) in response to a command from the battery diagnostic device 100 or the system controller 2. The electric motor 40 is driven using the alternating current power from the inverter 30. For the electric motor 40, for example, a three-phase AC motor may be used. The inverter 30, the electric motor 40, and other components within the battery system 1 that receive discharge power from the battery 11 may collectively be referred to as electrical loads.

The voltage sensor 111 is connected to the positive and negative terminals of each battery cell BC, and is configured to detect the voltage across both ends of the battery cell BC (which may also be referred to as the "full cell voltage") and generate a voltage signal representing the detected voltage value. The voltage sensor 111 may be implemented with one or a combination of two or more of known voltage detection elements, such as a voltage measurement integrated circuit (IC).

The current sensor 112 is connected in series to the battery 11 via a current path between the battery 11 and the inverter 30. The current sensor 112 is configured to detect the current flowing through the battery 11 (which may also be referred to as the "charge/discharge current") and to generate a current signal representing the detected current value. Since the multiple battery cells $BC_1$ to $BC_N$ are connected in series, the current flowing through the battery 11 is the same as the current flowing through each battery cell BC. The current sensor 112 may be implemented with one or a combination of two or more of known current detection elements, such as a shunt resistor or a Hall effect device.

The communication circuitry 130 is configured to support wired or wireless communications between the processor 150 and at least one of the system controller 2, the sensing circuitry 110, and an external device (not illustrated). The wired communication may be, for example, controller area network (CAN) communications, and the wireless communication may be, for example, Zigbee® or Bluetooth® communication. The type of communication protocol is not particularly limited as long as it supports wired and wireless communications between the processor 150 and the system controller 2. The communication circuitry 130 may include an output device (e.g., a display or a speaker) that provides information received from the processor 150 and/or the system controller 2 in a form recognizable by a user. The data acquisition unit (data acquisition circuitry) of the present disclosure may include at least one of the sensing circuitry 110 and the communication circuitry 130.

The processor 150 may be operatively coupled to at least one of the relay 20, the sensing circuitry 110, and the communication circuitry 130, as a control circuitry. The description "two components being operatively coupled" means that the two components are directly or indirectly connected to allow unidirectional or bidirectional signal transmission.

The processor 150 may be referred to a "battery controller" as a control circuitry and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or other electrical units for performing functions.

The memory 151 may include at least one type of storage medium, for example, a flash memory type, a hard disk type, a solid state disk (SSD) type, a silicon disk drive (SDD) type, a multimedia card micro type, random access memory (RAM), static random access memory (SRAM), read-only memory (ROM), electrically erasable programmable read-only memory (EEPROM), or programmable read-only memory (PROM). The memory 151 may store data and programs required for calculation operations by the processor 150. The memory 151 may store data representing the results of calculation operations by the processor 150. The memory 151 may store data sets and software used for diagnosing the degradation state of the battery cells BC. The memory 151 may be integrated into the processor 150.

The processor 150 may collect voltage signals from the sensing circuitry 110 and current signals from the current sensor 112. The term "detection signal," as used herein, may refer solely to a voltage signal or may be a collective term referring to both voltage and current signals. The processor 150 may convert and record each analog signal collected from the sensing circuitry 110 into digital values using an internally provided analog to digital converter (ADC). Alternatively, each of the voltage sensor 111 and the current sensor 112 may include an internal ADC and transmit the digital values generated by the ADC to the processor 150.

When the relay 20 is turned ON during the operation of the inverter 30, the motor 40, and/or the charger 3, which are electrical loads, the battery 11 enters either a charge mode or a discharge mode. When the relay 20 is turned OFF while the battery 11 is in use in the charge or discharge mode, the battery 11 is switched into an idle mode.

The processor 150 may turn ON the relay 20 in response to a key-ON signal. The processor 150 may turn OFF the relay 20 in response to a key-OFF signal. The key-ON signal is a signal requesting the switching from idle into charging or discharging. The key-OFF signal is a signal requesting switching from charging or discharging into idle. Alternatively, the ON/OFF control of the relay 20 may be performed by the system controller 2 instead of the processor 150.

In this specification, a time series of a certain parameter represents the temporal history of changes in that parameter over an arbitrary or specific period of time. In addition, a profile (or curve) representing the correspondence between any two parameters obtained at the same timing within the same period may be a representation obtained by mapping the time series data of the two parameters to be capable of being expressed in the form of a two-dimensional graph, or a polynomial equation obtained by applying a predetermined curve fitting logic to the pair of mapped time series data. Here, the degree of the highest-order term of the polynomial equation may be predetermined.

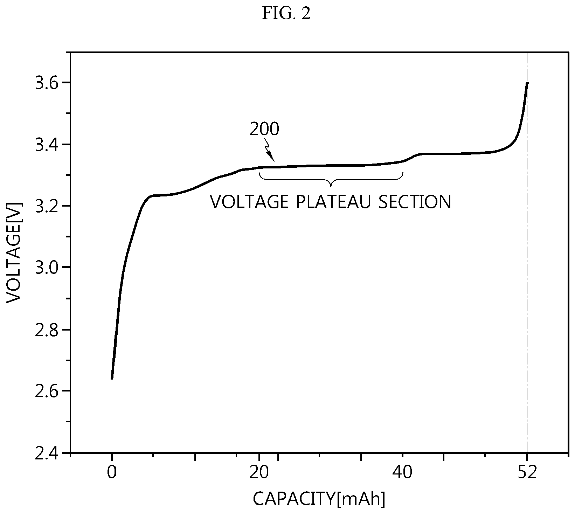

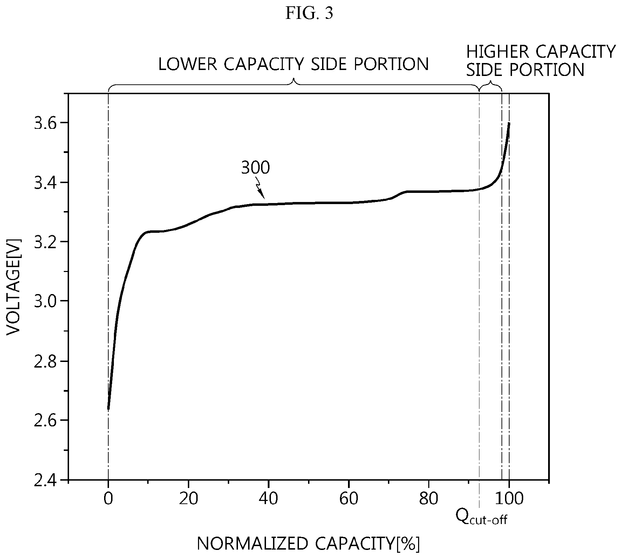

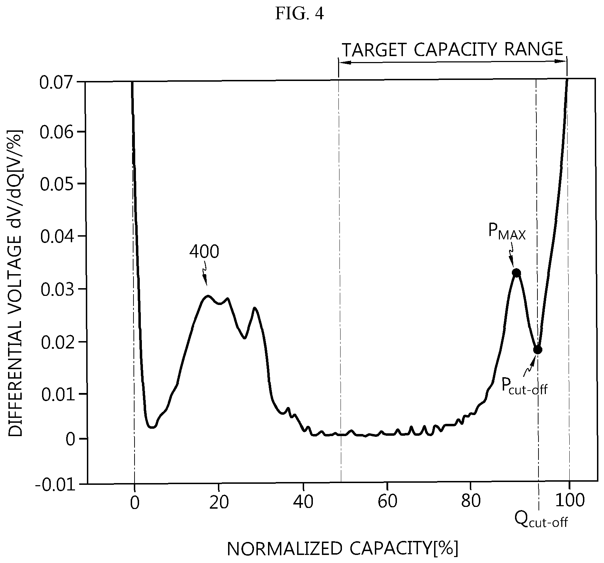

FIG. 2 is a graph illustrating an example of a Q-V profile of a battery cell, FIG. 3 is a graph illustrating an example of a normalized Q-V profile obtained from the Q-V profile of FIG. 2, and FIG. 4 is a graph illustrating an example of a Q-dV/dQ profile, which is a differential profile of the capacity associated with the normalized Q-V profile illustrated in FIG. 3.

In the graph illustrated in FIG. 2, the vertical axis represents the voltage V of a battery cell BC, while the horizontal axis represents the capacity in mAh. Reference numeral 200 denotes a Q-V profile based on the capacity-voltage relationship data of the battery cell BC.

The Q-V profile 200 may also be referred to as a "capacity-voltage profile," a "capacity-voltage curve," or a "voltage profile." As described above, the battery cell BC has a voltage plateau characteristic, and it may be observed from the Q-V profile 200 that the voltage remains nearly constant over a capacity range of about 20 to 40 mAh.

The Q-V profile 200 may be based on capacity-voltage relationship data acquired by the data acquisition unit while at least one of the charge cycle and discharge cycle of the battery cell BC is being performed. In conducting either the charge cycle or the discharge cycle, either a constant power or a constant current may be utilized. For convenience of explanation, the Q-V profile 200 will be assumed to be associated with the charge cycle. The details that will be described later regarding the charge cycle may also be applicable to the discharge cycle, except that a discharge current flows through the battery cell BC instead of a charge current.

In the constant power charge cycle, the charge current gradually decreases as the voltage of the battery cell BC increases. Therefore, in addition to the voltage time-series data representing the temporal history of changes in the voltage of the battery cell BC, the current time-series data, which represent the temporal history of changes in the current flowing through the battery cell BC, are also essentially required.

In the constant current charge cycle, the charge current with a predetermined current rate (*e.g.,* 0.1C, 0.5C, 1.5C, or 2.0C) is controlled to flow through the battery cell BC. Therefore, the capacity value at a specific point in time may be assumed to be equal to the value obtained by multiplying the elapsed time from the start of the constant current charge cycle to the specific point in time (*e.g.,* the time difference between the start of the constant current charge cycle and the specific point) by the current value corresponding to the current rate.

Even in the constant current charge cycle, the actual charge current may temporarily become greater or smaller than the originally intended charge current. For this reason, the processor 150 may generate capacity time-series data by repeating a procedure in which the current flowing through the battery cell BC is periodically measured using the current sensor 112, and integrating and recording the obtained current measurements.

The charge cycle may continue until the voltage of the battery cell BC changes across at least a predetermined voltage range. The Q-V profile 200 represents the relationship between the capacity and voltage of the battery cell BC, acquired over the period during which the voltage of the battery cell BC rises from the lower limit voltage to the upper limit voltage of the predetermined voltage range, as a result of the charge cycle.

The Q-V profile 200 illustrated in FIG. 2 illustrates an example in which the voltage of the battery cell BC increases from 2.6V (the predetermined lower limit voltage) to 3.6V (the predetermined upper limit voltage) while the capacity of the battery cell BC increases from 0mAh to 52mAh. Here, the range from 0mAh to 52mAh may be referred to as the total capacity range of the Q-V profile 200, which corresponds to the predetermined voltage range.

In this regard, the total capacity range corresponding to the predetermined voltage range may vary depending on factors such as the degradation state of the battery cell BC, rather than being fixed. Moreover, even when the degradation states of two different battery cells BC are identical, their capacity ranges may differ due to, for example, process deviations during manufacturing. Therefore, in order to enhance the ease and appropriateness of data processing required to diagnose the degradation state of the battery cell BC and ensure the accuracy of the diagnostic results, it is necessary to normalize the Q-V profile 200 by applying a normalization procedure to the total capacity range of the Q-V profile 200.

In the graph illustrated in FIG. 3, the vertical axis represents the voltage of a battery cell BC as in FIG. 2, while the horizontal axis represents the normalized capacity (unit: %). The normalized capacity may be a term equivalent to the conventional state of charge (SOC). Reference numeral "300" denotes an example of another Q-V profile obtained as a result of applying a normalization procedure to the Q-V profile 200.

When the capacity-voltage relationship according to the Q-V profile 200 has a mathematical relationship as expressed by Equation 1 below, the normalized capacity and voltage according to the Q-V profile 300 have a mathematical relationship as expressed by Equation 2 below. According to an embodiment, the Q-V profile 300 may be used as the "voltage profile" of the present disclosure.

<Equation 1>

$$V_B = f_1(Q_B)$$

<Equation 2>

$$V_B = f_2(Q_{B\_normal}) = f_2\left(\frac{Q_B}{Q_{total}} \times 100\right) = f_1\left(\frac{Q_{total} \times Q_{B\_normal}}{100}\right)$$

In Equation 1, $Q_B$ represents any capacity value within the total capacity range, and $V_B$ represents the voltage value of the data point corresponding to $Q_B$ in the Q-V profile 200. In Equation 2, $Q_{B\_normal}$ represents the normalized capacity value corresponding to $Q_B$, and $Q_{total}$ represents the size of the total capacity range (i.e., the upper limit capacity value of the total capacity range).

For reference, FIG. 3 represents the results of each data point in the total capacity range of FIG. 2 normalized to a percentage (ranging from 0 to 100%), but this should be understood as an example. For example, normalization may be performed over a different range, such as from 0 to 1, instead of the 0 to 100% range.

Referring to the graph illustrated in FIG. 4, reference numeral 400 denotes an example of the Q-dV/dQ profile. The Q-dV/dQ profile 400 may also be referred to as a "capacity-differential voltage profile," a "capacity-differential voltage curve," or a "differential voltage profile."

The processor 150 may generate the Q-dV/dQ profile 400 by differentiating the voltage of the Q-V profile 300 with respect to the capacity. For example, the processor 150 may determine the differential voltage dV/dQ, which is the ratio of the change amount dV of the voltage V to the change amount dQ of the normalized capacity Q [%], based on the Q-V profile 300, and may determine the Q-dV/dQ profile 400 as relationship data indicating the corresponding relationship between the normalized capacity Q [%] and the differential voltage dV/dQ. The Q-dV/dQ profile 400 may be recorded in the memory 151 of the processor 150.

The processor 150 may determine a characteristic point from the Q-dV/dQ profile 400. The characteristic point of the Q-dV/dQ profile 400 may be a data point located within a predetermined target capacity range on the Q-dV/dQ profile 400. In FIG. 4, the target capacity range is illustrated as being 50% to 99%. The target capacity range may partially overlap with the capacity range where the voltage plateau characteristic of the battery cell BC is expressed.

For example, the processor 150 may identify a local maximum point ($P_{MAX}$) with the highest differential voltage value within the target capacity range from the Q-dV/dQ profile 400. Subsequently, the processor 150 may determine a data point located on the higher capacity side relative to the local maximum point ($P_{MAX}$) from the Q-dV/dQ profile 400 as the characteristic point ($P_{cut-off}$). The characteristic point of the Q-dV/dQ profile 400 may also be referred to as a "cut-off reference point."

When two or more local minimum points exist within the target capacity range, any one of the local minimum points with the largest capacity value $Q_{cut-off}$ among them may be set as the characteristic point $P_{cut-off}$.

The characteristic point $P_{cut-off}$ may be the final local minimum point on the Q-dV/dQ profile 400 due to the voltage characteristic of the negative electrode material of the battery cell BC. For example, the portion on the higher capacity side beyond the characteristic point $P_{cut-off}$ may correspond to a capacity range where the voltage characteristic of the positive electrode material of the battery cell BC dominates over that of the negative electrode material. Therefore, it would be readily understood by those skilled in the art that, if only the higher capacity side portion of the overall Q-V profile 300 is specified as the analysis target, it would be possible to accurately estimate a degradation parameter caused by the positive electrode degradation of the battery cell BC.

In the present disclosure, it has been confirmed through numerous experiments that the voltage characteristics of the negative electrode material are reflected relatively minimally in the portion on the higher capacity side beyond the characteristic point $P_{cut-off}$ compared to other portions of the Q-V profile 300. Therefore, it has also been recognized through the present disclosure that analyzing the higher capacity side portion of the overall Q-V profile 300 enables accurate diagnosis of parameters related to positive electrode degradation among various degradation parameters associated with the degradation state of the battery cell BC.

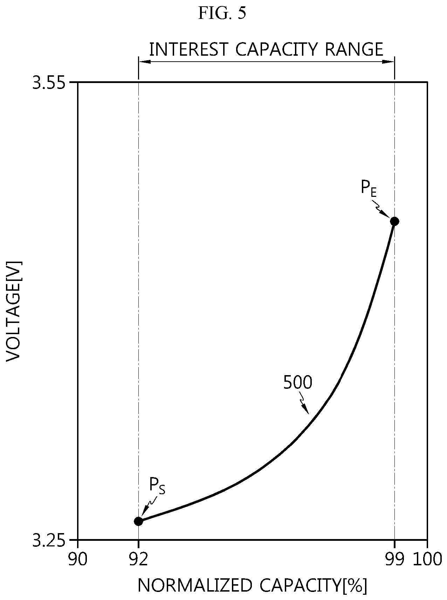

In this specification, when the Q-V profile 300 is divided into a lower capacity side portion and a higher capacity side portion based on the capacity value $Q_{cut-off}$ of the characteristic point $P_{cut-off}$, as in FIG. 3, the higher capacity side portion will be referred to as the "first interest profile" (see reference numeral 500 in FIG. 5).

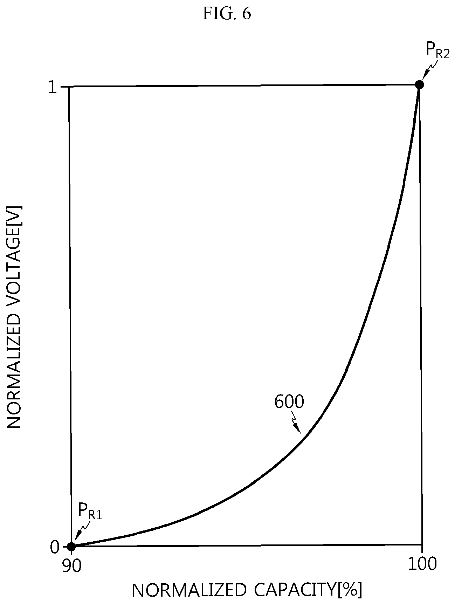

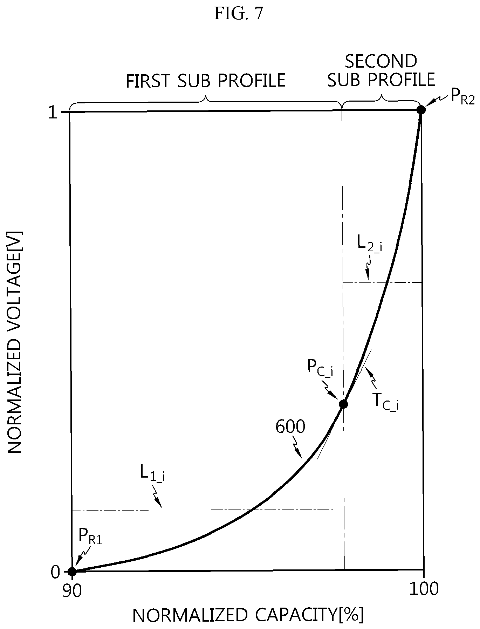

FIG. 5 is a graph illustrating an example of a first interest profile, FIG. 6 is a graph illustrating an example of a second interest profile, and FIG. 7 is a diagram referenced to explain a procedure for determining the characteristic slope of the second interest profile illustrated in FIG. 6.

Referring to FIG. 5, the first interest profile 500 is an enlarged view of a portion of the Q-V profile 300 corresponding to an interest capacity range (*e.g.,* 92% to 99%), where the capacity value of the characteristic point $P_{cut-off}$ (*e.g.,* 92%) and the upper limit capacity value of the target capacity range (*e.g.,* 99%) are the lower limit and upper limit, respectively.

In this regard, even when the positive electrode degradation state of the battery cell BC is the same, when other degradation factors, such as the negative electrode degradation state or the available lithium amount, differ, the start point, end point, and/or shape (*e.g.,* curvature) of the first interest profile 500 may vary. Therefore, it is necessary to apply a normalization procedure to the first interest profile 500, similar to the normalization procedure applied to the Q-V profile 200.

Referring to FIG. 6, a second interest profile 600, which is the result obtained by applying the normalization procedure to the first interest profile 500, may be identified.

The processor 150 may determine the second interest profile 600 by normalizing the capacity-voltage domain of the first interest profile 500 to match a predetermined reference capacity-voltage domain. The reference capacity-voltage domain may be a rectangular region defined by a reference capacity range and a reference voltage range.

For example, the processor 150 may generate the second interest profile 600 by applying a normalization procedure to the first interest profile 500 such that the start point $P_S$ and the end point $P_E$ of the first interest profile 500 match a predetermined first reference point $P_{R1}$ and a second reference point $P_{R2}$, respectively. The reference capacity range may be the capacity range between the first reference point $P_{R1}$ and the second reference point $P_{R2}$, and the reference voltage range may be the voltage range between the first reference point $P_{R1}$ and the second reference point $P_{R2}$.

The start point $P_S$ of the first interest profile 500 may be a data point with the minimum capacity value of the first interest profile 500. The end point $P_E$ of the first interest profile 500 may be a data point with the maximum capacity value of the first interest profile 500.

The capacity value of the first reference point $P_{R1}$ may be smaller than the capacity value of the start point $P_S$, and the voltage value of the first reference point $P_{R1}$ may be smaller than the voltage value of the start point $P_S$. In addition, the capacity value of the second reference point $P_{R2}$ may be greater than the capacity value of the end point $P_E$, and the voltage value of the second reference point $P_{R2}$ may be greater than the voltage value of the end point $P_E$.

The processor 150 may execute a first operation of shifting the first interest profile 500 along the horizontal axis (capacity axis) and the vertical axis (voltage axis) such that the start point $P_S$ matches the first reference point $P_{R1}$ or the end point $P_E$ matches the second reference point $P_{R2}$, and a second operation of scaling the first interest profile 500 along the capacity axis and the voltage axis. The first operation may include at least one of horizontal movement (leftward or rightward movement along the horizontal axis) and vertical movement (upward or downward movement along the vertical axis). The second operation may include at least one of scaling-down or scaling-up along at least one of the horizontal axis and the vertical axis.

It is assumed that the two-dimensional coordinates of the start point $P_S$, the end point $P_E$, the first reference point $P_{R1}$, and the second reference point $P_{R2}$ are $(Q_S, V_S)$, $(Q_E, V_E)$, $(Q_{R1}, V_{R1})$, and $(Q_{R2}, V_{R2})$, respectively. In FIG. 6, the two-dimensional coordinates $(Q_{R1}, V_{R1})$ of the first reference point $P_{R1}$ are illustrated as (90%, 0V), and the two-dimensional coordinates $(Q_{R2}, V_{R2})$ of the second reference point $P_{R2}$ are illustrated as (100%, 1V).

The processor 150 may shift the first interest profile 500 toward the low-capacity side by an amount of $Q_S - Q_{R1}$ and toward the low-voltage side by an amount of $V_S - V_{R1}$. As a result, since the start point $P_S$ matches the first reference point $P_{R1}$, it becomes necessary to match the end point $P_E$ to the second reference point $P_{R2}$. Therefore, the processor 150 may scale the first interest profile 500 along the capacity axis at a ratio of $(Q_{R2} - Q_{R1})/(Q_E - Q_S)$ and along the voltage axis at a ratio of $(V_{R2} - V_{R1})/(V_E - V_S)$. As a result, the end point $P_E$ matches the second reference point $P_{R2}$, thereby completing the normalization procedure that determines the second interest profile 600 from the first interest profile 500. Also, the second interest profile 600 may be the result of projecting the first interest profile 500 onto the reference capacity-voltage domain.

When the capacity and voltage according to the first interest profile 500 have a mathematical relationship as expressed in Equation 3 below, the capacity and voltage, according to the second interest profile 600 have a mathematical relationship as expressed in Equation 4 below.

<Equation 3>

$$V_B = f_3\left(Q_{B\_normal}\right)$$

<Equation 4>

$$V_{B\_normal} = f_4\left(Q_{B\_normal\_2}\right) = f_4\left(\frac{Q_{total\_normal\_2}}{Q_{total\_normal}} \times \left(Q_{B\_normal} - Q_S\right) + Q_{R1}\right)$$
$$= f_3\left(Q_{B\_normal}\right) \times \frac{V_{R2} - V_{R1}}{V_E - V_S}$$

In Equation 3, $Q_{B\_normal}$ represents the capacity value of an arbitrary data point on the first interest profile 500, and $V_B$ represents the voltage value mapped to $Q_{B\_normal}$ in the first interest profile 500.

In Equation 4, $Q_{B\_normal\_2}$ represents the capacity value of the second interest profile 600 corresponding to $Q_{B\_normal}$. For reference, FIG. 6 represents the results of each data point in the total voltage range of FIG. 5 normalized to a range of 0 to 1V, but this should be understood as an example.

The processor 150 may determine the characteristic slope of the second interest profile 600. Since the second interest profile 600 is based on the first interest profile 500, the characteristic slope may be associated with the first interest profile 500.

The second interest profile 600 may be regarded as a set of multiple data points, each representing a normalized capacity and a normalized voltage.

In the following, it is assumed that the second interest profile 600 includes first to $n^{th}$ data points. Here, n is a natural number of 3 or more. The difference in capacity between any two adjacent data points among the first to the $n^{th}$ data points may be constant at a predetermined value. Alternatively, the difference in voltage between any two adjacent data points among the first to the $n^{th}$ data points may be constant at a predetermined value.

The first data point may be identical to the first reference point $P_{R1}$, and the $n^{th}$ data point may be identical to the second reference point $P_{R2}$. Alternatively, the first data point may have a capacity value greater than the capacity value of the first reference point $P_{R1}$ by a predetermined value, and the $n^{th}$ data point may have a capacity value smaller than the capacity value of the second reference point $P_{R2}$ by a predetermined value. Alternatively, the first data point may have a voltage value greater than the voltage value of the first reference point $P_{R1}$ by a predetermined value, and the $n^{th}$ data point may have a voltage value smaller than the voltage value of the second reference point $P_{R2}$ by a predetermined value.

In the present disclosure, it is assumed that the symbol i, used as an ordinal number, is a natural number equal to or less than n.

Referring to FIG. 7, the processor 150 may divide the second interest profile 600 into a first sub-profile and a second sub-profile based on the capacity value of an $i^{th}$ data point $P_{C\_i}$ among the first to $n^{th}$ data points. The first sub-profile may be a portion of the second interest profile 600 corresponding to the capacity range that is less than or equal to the capacity value of the $i^{th}$ data point $P_{C\_i}$. The second sub-profile may be a portion of the second interest profile 600 corresponding to the capacity range that is greater than or equal to the capacity value of the $i^{th}$ data point $P_{C\_i}$. For example, when n = 1,000 and i = 700, the first sub-profile may include the first to $700^{th}$ data points, and the second sub-profile may include the $700^{th}$ to $1,000^{th}$ data points.

Next, the processor 150 may determine the average voltage value of the first sub-profile and the average voltage value of the second sub-profile. The average voltage value of the first sub-profile may be the average of the voltage values of the data points included in the first sub-profile. The average voltage value of the second sub-profile may be the average of the voltage values of the data points included in the second sub-profile.

Subsequently, the processor 150 may determine the $i^{th}$ comparison value $P_{C\_i}$ of the $i^{th}$ data point as being equal to the sum of a first error value based on the average voltage value of the first sub-profile and a second error value based on the average voltage value of the second sub-profile. In FIG. 7, the voltage line $L_{1\_i}$ represents the average voltage of the first sub-profile, and the voltage line $L_{1\_2}$ represents the average voltage of the second sub-profile.

The processor 150 may determine (i) the first error value of the first sub-profile based on the average voltage of the first sub-profile and (ii) the second error value of the second sub-profile based on the average voltage of the second sub-profile. Each error value may be determined using at least one of well-known algorithms that quantify the level of difference between two data sets, such as a mean square error (MSE) or a root mean square error (RMSE). For example, the first error value may be a value obtained by summing the squares of the voltage differences of all data points of the first sub-profile relative to the average voltage value of the first sub-profile. As another example, the second error value may be a value obtained by summing the squares of the voltage differences of all data points of the second sub-profile relative to the average voltage value of the second sub-profile.

Next, the processor 150 may determine the $i^{th}$ comparison value to be equal to the sum of the first error value and the second error value. By individually setting natural numbers equal to or less than n as i and repeating the aforementioned processes n times, multiple comparison values individually associated with multiple data points may be determined.

The processor 150 may determine one of the multiple data points associated with the minimum value among the multiple comparison values as a characteristic point of the second interest profile 600.

Subsequently, the processor 150 may determine a characteristic slope to be equal to the slope of the tangent at the characteristic point of the second interest profile 600. In FIG. 7, the symbol $T_{C\_i}$ illustrates the tangent at the $i^{th}$ data point $P_{C\_i}$. When the $i^{th}$ data point $P_{C\_i}$ is identified as the characteristic point of the second interest profile 600, the slope of the tangent $T_{C\_i}$ may be determined as the characteristic slope.

The processor 150 may determine a first degradation parameter by using the characteristic slope as an input variable in a linear regression model. The first degradation parameter may indicate the capacity reduction ratio caused by the positive electrode degradation of the battery cell.

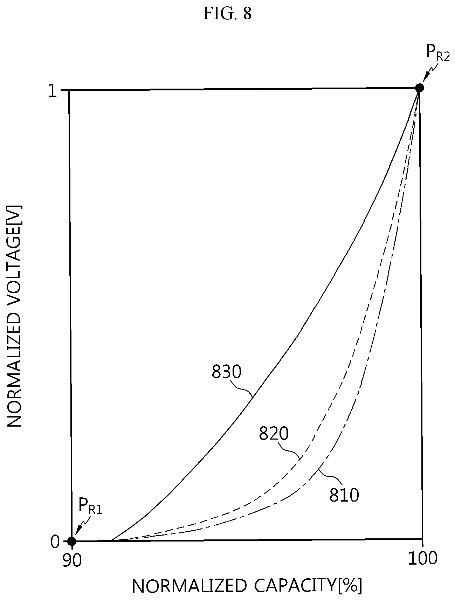

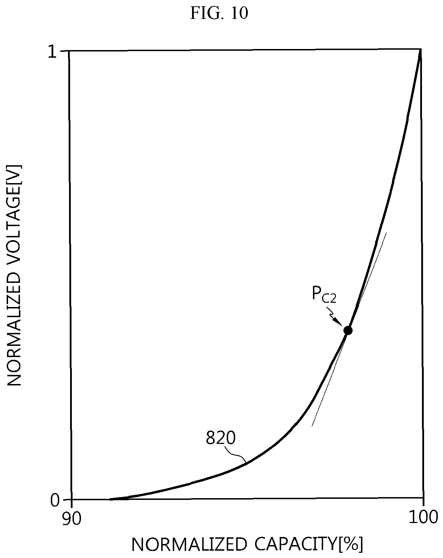

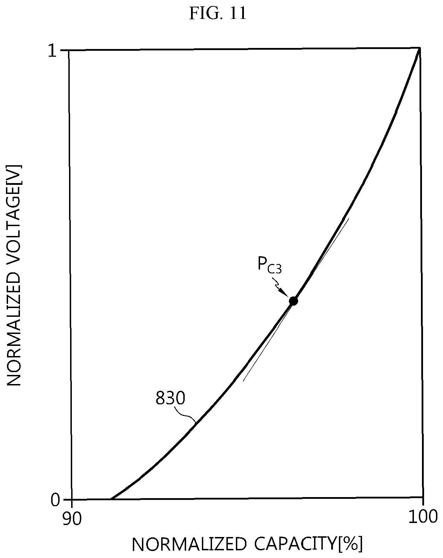

The capacity reduction rate due to positive electrode degradation may be referred to as a "positive electrode degradation degree" or a "positive electrode degradation-derived capacity reduction ratio." Hereinafter, a more detailed description of the linear regression model will be provided with reference to FIGS. 8 to 12.

According to an embodiment of the present disclosure, relationship data that may be generated using a linear regression model was obtained by sequentially performing the following processes: a first process of forcibly degrading multiple battery cells prepared as experimental samples to have different positive electrode degradation degrees; a second process of determining the characteristic slope associated with each forcibly degraded battery cell; a third process of disassembling each forcibly degraded battery cell to fabricate a positive electrode half-cell; and a fourth process of measuring and recording the available capacity (*e.g.*, the maximum capacity) of each positive electrode half-cell.

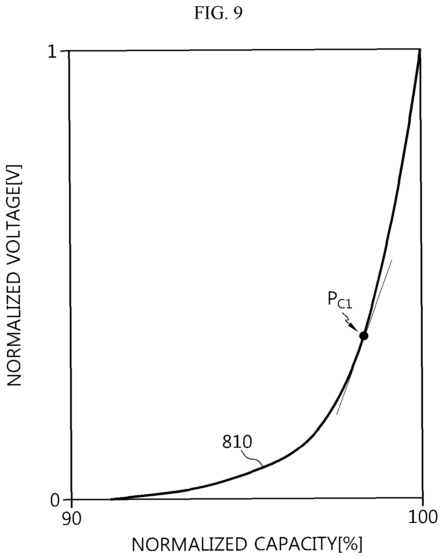

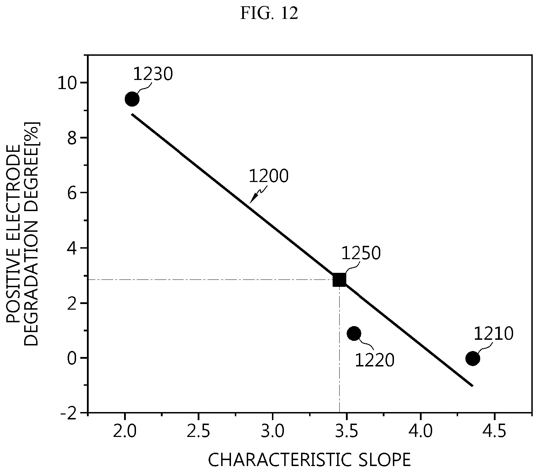

FIG. 8 is an example diagram referenced to explain the relationship between positive electrode degradation degrees and second interest profiles, FIGS. 9 to 11 are diagrams respectively referenced to explain the characteristic slopes of the three second interest profiles illustrated in FIG. 8, and FIG. 12 is an example diagram referenced to explain the relationship between the positive electrode degradation degree and the characteristic slope.

FIG. 8 illustrates the change pattern of the shape of the second interest profile as the positive electrode degradation degree increases. The positive electrode degradation degree may refer to the capacity reduction ratio caused by positive electrode degradation.

Referring to FIG. 8, the curve 810 represents the second interest profile when the positive electrode is in a new product state with no degradation, the curve 820 represents the second interest profile when the positive electrode degradation degree is 1.75%, and the curve 830 represents the second interest profile when the positive electrode degradation degree is 9.40%.

For example, as the positive electrode degradation degree increases, the second interest profile gradually changes to resemble a straight line connecting the first reference point $P_{R1}$ and the second reference point $P_{R2}$, and thus, it may be confirmed from FIGS. 9 to 11 that the characteristic point of the second interest profile shifts toward the low-capacity side.

Referring to FIGS. 9 to 11, each of the curves 810, 820, and 830 is illustrated as a polynomial with the highest degree being 3. In addition, the characteristic slopes of the curves 810, 820, and 830 are 4.35, 3.45, and 2.05, respectively, from which it may be seen that the characteristic slope decreases as the positive electrode degradation degree increases.

Referring to FIG. 12, the linear regression model 1200 has been prepared in advance as relational data representing the correspondence between the characteristic slope and the positive electrode degradation state. In the graph of FIG. 12, the data point 1210 is associated with the curve 810 in FIG. 8, the data point 1220 is associated with the curve 820 in FIG. 8, and the data point 1230 is associated with the curve 830 in FIG. 8. Although not all of the data points are illustrated, in the present disclosure, additional data points other than the data points 1210, 1220, and 1230 were obtained as a result of the aforementioned experiment and used to derive the linear regression model 1200 through linear regression analysis. The linear regression model 1200 may be stored in advance in the memory 151 of the processor 150. Equation 5 below provides an example of the linear regression model 1200.

<Equation 5>

$$y = Ax + B$$

In Equation 5, "A" and "B" are two coefficients that respectively represent the slope and y-axis intercept of a straight line, according to the linear regression model 1200. The symbol "x" represents the characteristic slope as an input variable (see FIG. 7), and the symbol "y" represents the positive electrode degradation degree as an output variable. The coefficients A and B may vary depending on factors such as the type and composition ratio of each of the positive and negative electrode materials. Therefore, the coefficients A and B may be appropriately tuned according to the type and manufacturing information (*e.g.,* the type and composition ratio of each of the positive and negative electrode materials) of the battery cell BC provided as the target of diagnosis. For example, the coefficients A and B of the linear regression model 1200 illustrated in FIG. 12 are -4.29 and 17.66, respectively.

The processor 150 may acquire the positive electrode degradation degree as an output variable y by inputting the characteristic slope, determined based on the capacity-voltage relationship data of the battery cell BC with an unknown positive electrode degradation state, into the linear regression model 1200, as an input variable x. For example, when the characteristic slope of the battery cell BC is determined to be 3.45, the positive electrode degradation degree of the battery cell BC may be determined to be about 2.86% by the linear regression model 1200 ($y = -4.29 \times 3.45 + 17.66$). In FIG. 12, reference numeral 1250 represents a data point corresponding to a characteristic slope of 3.45 and a positive electrode degradation degree of 2.86%.

Table 1 below summarizes the relationship among the number of completed charge cycles (number of cycles) described above, the total capacity reduction ratio, the characteristic slope, the first degradation parameter (capacity reduction ratio caused by positive electrode degradation), and the second degradation parameter (capacity reduction ratio caused by available lithium loss). Here, the "available lithium" may refer to the lithium ions capable of participating in the charge and discharge reactions of the battery cell BC.

[Table 1]

| Class. | Total capacity reduction ratio (%) | Characteristic Slope | Capacity reduction ratio caused by positive electrode degradation (%) | Capacity reduction ratio caused by available lithium loss (%) |
|---|---|---|---|---|
| Number of cycles = 0 | 0 | 4.35 | 0 | 0 |

(continued)

| Class. | Total capacity reduction ratio (%) | Characteristic Slope | Capacity reduction ratio caused by positive electrode degradation (%) | Capacity reduction ratio caused by available lithium loss (%) |
|---|---|---|---|---|
| Number of cycles = 200 | 6.70 | 3.45 | 2.86 | 3.84 |
| Number of cycles = 600 | 16.5 | 2.05 | 9.40 | 7.10 |

According to Table 1, it may be understood that as the number of cycles increases, the characteristic slope decreases, while the total capacity reduction ratio, the first degradation parameter, and the second degradation parameter each increase correspondingly. For reference, the number of cycles may be incremented by one each time a charge cycle or discharge cycle is completed.

The total capacity reduction ratio may be the ratio of the reduction in the fully charged capacity due to degradation to the designed capacity (*e.g.*, the fully charged capacity in the new product state) of the battery cell BC. As an example, when it is assumed that the designed capacity is P, the current fully charged capacity is U, and the reduction in the fully charged capacity is W, then, W = P - U, and the total capacity reduction ratio = (W/P) $\times$ 100%.

In the present disclosure, it has been recognized that the sum of the first degradation parameter and the second degradation parameter is substantially equal to the total capacity reduction ratio. Accordingly, the processor 150 may determine the second degradation parameter, which represents the capacity reduction ratio due to available lithium loss, by subtracting the capacity reduction ratio represented by the first degradation parameter from the total capacity reduction ratio.

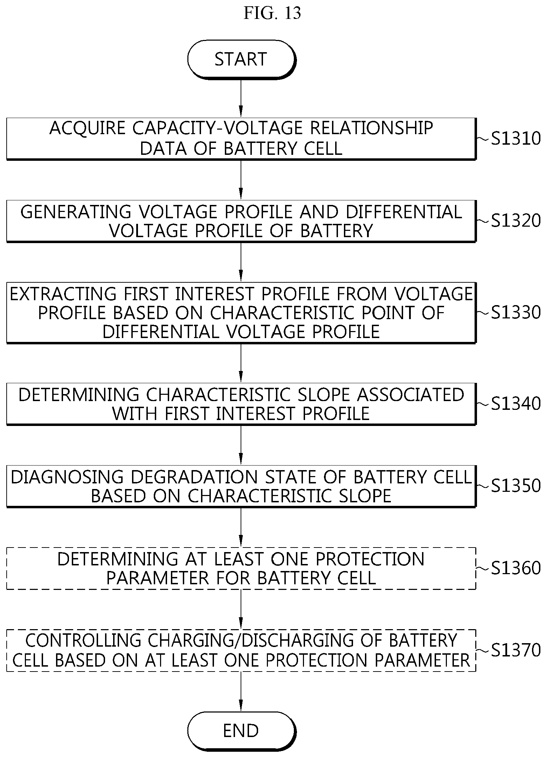

FIG. 13 is a flowchart schematically illustrating a battery diagnosis method according to an embodiment of the present disclosure. The method according to FIG. 13 includes steps S1310 to S1360. The method according to FIG. 13 may further include step S1370.

In step S1310, the data acquisition unit acquires the capacity-voltage relationship data of a battery cell BC. In this specification, the acquisition of any data or information may refer to generation through software processing, input via a user or input device, and/or reception through a communication channel.

As an example, when the data acquisition unit includes a sensing circuitry 110, the data acquisition unit may generate a voltage time series and a capacity time series based on detection signals generated by the sensing circuitry 110. The capacity-voltage relationship data may include the voltage time series and the capacity time series.

As another example, when the data acquisition unit includes a communication circuitry 130, the data acquisition unit may receive capacity-voltage relationship data from an external device using the communication circuitry 130.

In step S1320, the processor 150 generates a voltage profile 300 and a differential voltage profile 400 of the battery cell BC based on the capacity-voltage relationship data acquired in step S1310.

In step S1330, the processor 150 extracts a first interest profile 500 from the voltage profile 300 based on a characteristic point $P_{cut-off}$ of the differential voltage profile 400.

In step S1340, the processor 150 determines the characteristic slope of the first interest profile 500.

In step S1350, the degradation state of the battery cell BC is diagnosed based on the characteristic slope of the first interest profile 500. In step S1350, the processor 150 may determine a first degradation parameter y, associated with the degradation state of the battery cell BC, by using the characteristic slope determined in step S1340 as an input variable x for a linear regression model 1200 (see, *e.g.*, Equation 5). The linear regression model 1200 may be prepared in advance as relational data representing the correspondence between the characteristic slope and the positive electrode degradation state of the battery cell BC. Accordingly, the second degradation parameter, which represents the capacity reduction ratio (%) due to available lithium loss, may be additionally determined by determining the first degradation parameter, which indicates the capacity reduction ratio (%) caused by positive electrode degradation and subtracting the first degradation parameter from the total capacity reduction ratio (%).

In step S1360, the processor 150 may determine at least one protection parameter for the battery cell BC based on the result of the diagnosis performed in step S1350. For example, at least one of a maximum charge voltage, a minimum discharge voltage, a maximum allowable current, and a maximum allowable power may be determined as the protection parameter.

In step S1370, the processor 150 controls the charging and discharging of the battery cell based on the at least one protection parameter. For example, the processor 150 may switch the relay 20 to an off state or transmit an operation stop request to the inverter 30 and/or the charger 3 when (i) the voltage of the battery cell BC is greater than or equal to the maximum charge voltage or less than or equal to the minimum discharge voltage, (ii) the current flowing through the battery cell BC is equal to or higher than the maximum allowable current, and/or (iii) the charge power or discharge power of the battery cell BC is greater than or equal to the maximum allowable power.

In the method of FIG. 13, at least one of steps 1360 and S1370 may be omitted.

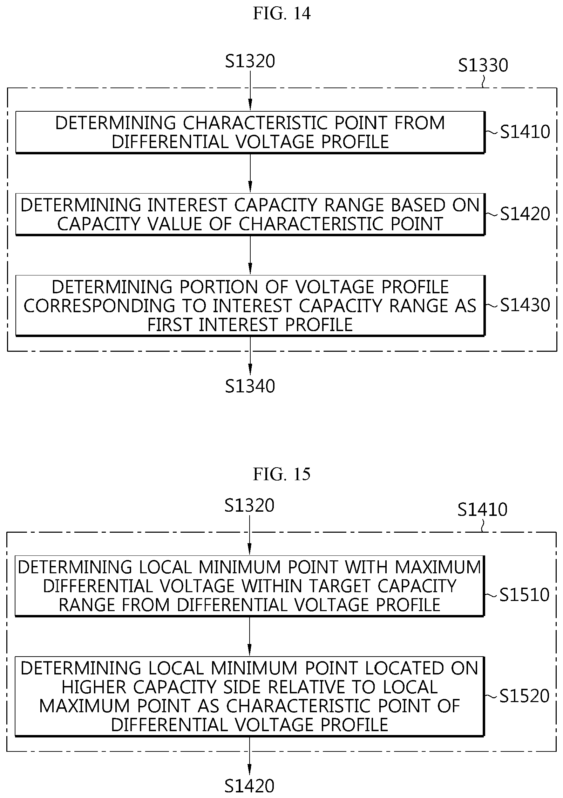

FIG. 14 is a flowchart illustrating subroutines that may be included in step S1330 of FIG. 13.

Referring to FIG. 14, in step S1410, the processor 150 determines a characteristic point $P_{cut-off}$ from the differential voltage profile 400.

In step S1420, the processor 150 determines an interest capacity range $P_S$ to $P_E$ based on the capacity value $Q_{cut-off}$ of the characteristic point $P_{cut-off}$.

In step S1430, the processor 150 determines a portion of the voltage profile 300 corresponding to the interest capacity range $P_S$ to $P_E$ as the first interest profile 500. The first interest profile 500 may be the high-capacity side portion of the voltage profile 300 when bisected with respect to the capacity value $Q_{cut-off}$ of the characteristic point $P_{cut-off}$.

FIG. 15 is a flowchart illustrating subroutines that may be included in step S1410 of FIG. 14.

Referring to FIG. 15, in step S1510, the processor 150 detects a local maximum point $P_{MAX}$ with the maximum differential voltage within the target capacity range from the differential voltage profile 400.

In step S1520, the processor 150 determines a local minimum point, which is located on the higher capacity side relative to the local maximum point $P_{MAX}$ in the differential voltage profile 400, as the characteristic point $P_{cut-off}$ of the differential voltage profile 400.

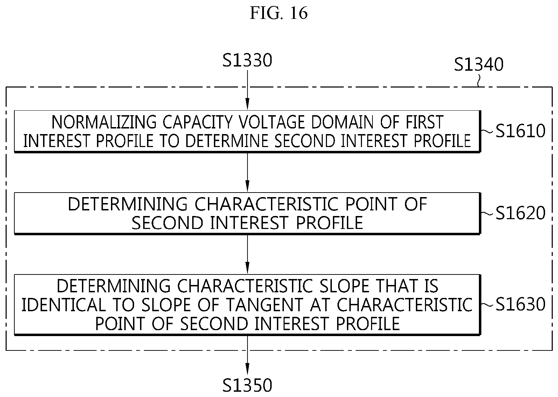

FIG. 16 is a flowchart illustrating subroutines that may be included in step S 1330 of FIG. 13.

Referring to FIG. 16, in step S1610, the processor 150 determines a second interest profile 600 by normalizing the capacity-voltage domain of the first interest profile 500. The second interest profile 600 may be the result of executing shifting and scaling operations for the first interest profile 500 such that the start point $P_S$ and the end point $P_E$ of the first interest profile 500 correspond to a predetermined first reference point $P_{R1}$ and a second reference point $P_{R2}$, respectively.

In step S1620, the processor 150 determines a characteristic point of the second interest profile 600. The characteristic point (e.g., $T_{C\_i}$) of the second interest profile 600 is any one of the multiple data points of the second interest profile 600.

In step S1630, the processor 150 determines a characteristic slope to be identical to the slope of the tangent at the characteristic point of the second interest profile 600.

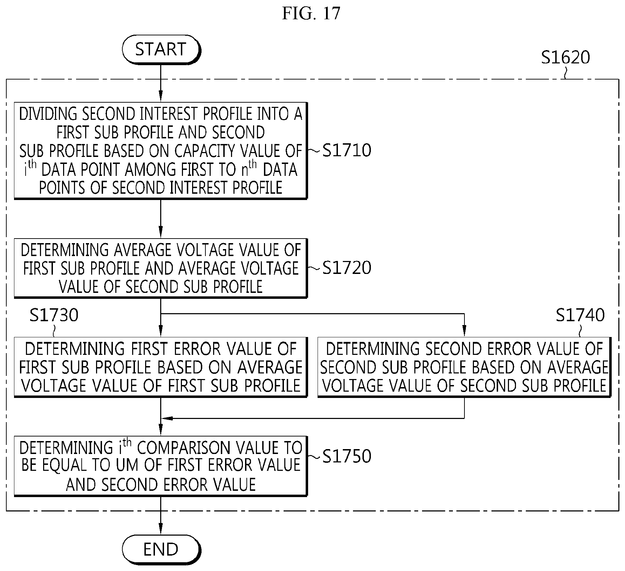

FIG. 17 is a flowchart illustrating subroutines that may be included in step S1620 of FIG. 16.

Referring to FIG. 17, in step S1710, the processor 150 divides the second interest profile 600 into a first sub-profile and a second sub-profile, based on the capacity value of an $i^{th}$ data point $P_{C\_i}$ among first to $n^{th}$ data points of the second interest profile 600 (see FIG. 7).

In step S1720, the processor 150 determines the average voltage value of the first sub-profile and the average voltage value of the second sub-profile.

In step S1730, the processor 150 determines a first error value of the first sub-profile based on the average voltage value of the first sub-profile.

In step S1740, the processor 150 determines a second error value of the second sub-profile based on the average voltage value of the second sub-profile.

In step S1750, the processor 150 determines an $i^{th}$ comparison value to be identical to the sum of the first error value and the second error value.

When the method illustrated in FIG. 17 is repeated, with i as the natural numbers up to n, first to $n^{th}$ comparison values are determined. The processor 150 may determine any one data point associated with the minimum comparison value among the first to $n^{th}$ comparison values as a characteristic point of the second interest profile 600.

The above-described embodiments of the present disclosure are not limited to being implemented solely through apparatuses and methods, but may also be implemented through a program that implements the functions corresponding to the configuration of the embodiments of the present disclosure or through a recording medium on which such a program is recorded. This may be readily implemented by a person ordinarily skilled in the technical field to which the present disclosure belongs based on the description of the embodiments described above.

While the present disclosure has been described above with reference to several embodiments and drawings, the present disclosure is not limited thereto, and various changes and modifications can be made by a person ordinarily skilled in the art to which the present disclosure pertains without departing from the technical spirit of the present disclosure and the equivalent scope of the claims to be described below.

In addition, since various substitutions, modifications, and changes can be made to the present disclosure as described above without departing from the technical spirit of the present disclosure by a person ordinarily skilled in the art to which the present disclosure pertains, the present disclosure is not limited to the above-described embodiments and the accompanying drawings, but all or some of the respective embodiments can be selectively combined so that various modifications can be made.

**Claims**

1. A battery diagnostic apparatus comprising:

data acquisition circuitry configured to acquire capacity-voltage relationship data of a battery cell; and
a processor configured to generate a voltage profile and a differential voltage profile of the battery based on the capacity-voltage relationship data,
wherein the processor is configured to:

extract a first interest profile from the voltage profile based on a characteristic point of the differential voltage profile;
determine a characteristic slope associated with the first interest profile; and
diagnose a degradation state of the battery cell based on the characteristic slope.

2. The battery diagnosis apparatus of claim 1, wherein the processor is configured to:
determine a data point having a minimum differential voltage value within a target capacity range as the characteristic point of the differential voltage profile.

3. The battery diagnosis apparatus of claim 1, wherein the processor is configured to:

determine an interest capacity range based on a capacity value of the characteristic point of the differential voltage profile; and
determine a portion of the voltage profile corresponding to the interest capacity range as the first interest profile.

4. The battery diagnosis apparatus of claim 1, wherein the processor is configured to:

normalize a capacity-voltage domain of the first interest profile to match a reference capacity-voltage domain to determine a second interest profile; and
determine the characteristic slope to be equal to a slope of a tangent at a characteristic point of the second interest profile.

5. The battery diagnosis apparatus of claim 4, wherein the processor is configured to:

determine a plurality of comparison values respectively associated with multiple data points of the second interest profile; and
determine any one of the multiple data points associated with a minimum of the multiple comparison values as the characteristic point of the second interest profile.

6. The battery diagnosis apparatus of claim 5, wherein the processor is configured to:

divide the second interest profile into a first sub-profile and a second sub-profile based on a capacity value of each of the multiple data points; and
determine the comparison value of each of the multiple data points to be equal to a sum of a first error value based on an average voltage value of the first sub-profile and a second error value based on an average voltage value of the second sub-profile.

7. The battery diagnosis apparatus of claim 1, wherein the processor is configured to:
determine a first degradation parameter representing a capacity reduction ratio caused by positive electrode degradation of the battery cell using the characteristic slope as an input variable for a linear regression model.

8. The battery diagnosis apparatus of claim 7, wherein the processor is configured to:
determine a second degradation parameter representing a capacity reduction ratio caused by available lithium loss in the battery cell based on a total capacity reduction ratio of the battery cell and the first degradation parameter.

9. The battery diagnosis apparatus of claim 1, wherein the capacity-voltage relationship data includes a capacity time series and a voltage time series of the battery cell during charging or discharging of the battery cell.

10. A battery pack comprising the battery diagnosis apparatus of any one of claims 1 to 9.

11. A battery system comprising the battery diagnosis apparatus of any one of claims 1 to 9.

12. A method for diagnosing a battery pack, the method comprising:

    acquiring capacity-voltage relationship data of a battery cell;
    generating a voltage profile and a differential voltage profile of the battery cell based on the capacity-voltage relationship data;
    extracting a first interest profile from the voltage profile based on a characteristic point of the differential voltage profile;
    determining a characteristic slope associated with the first interest profile; and
    diagnosing a degradation state of the battery cell based on the characteristic slope.

13. The method of claim 12, wherein the extracting the first interest profile from the voltage profile includes:

    determining an interest capacity range based on a capacity value of the characteristic point of the differential voltage profile; and
    determining a portion of the voltage profile corresponding to the interest capacity range as the first interest profile.

14. The method of claim 12, wherein the determining the characteristic slope associated with the first interest profile further includes:

    normalizing a capacity-voltage domain of the first interest profile to match a reference capacity-voltage domain, thereby determining a second interest profile; and
    determining the characteristic slope to be equal to a slope of a tangent at a characteristic point of the second interest profile.

15. The method of claim 14, wherein the determining the characteristic slope associated with the first interest profile further includes:

    determining multiple comparison values respectively associated with multiple data points of the second interest profile; and
    determining any one of the multiple data points associated with a minimum of the multiple comparison values as the characteristic point of the second interest profile.

16. A non-transitory computer-readable recording medium storing a computer program including instructions that, when executed by a processor, cause the processor to perform operations including:

    acquiring capacity-voltage relationship data of a battery cell;
    generating a voltage profile and a differential voltage profile of the battery cell based on the capacity-voltage relationship data;
    extracting a first interest profile from the voltage profile based on a characteristic point of the differential voltage profile;
    determining a characteristic slope associated with the first interest profile; and
    diagnosing a degradation state of the battery cell based on the characteristic slope.

17. The recording medium of claim 16, wherein the extracting the first interest profile from the voltage profile includes:

    determining an interest capacity range based on a capacity value of the characteristic point of the differential voltage profile; and
    determining a portion of the voltage profile corresponding to the interest capacity range as the first interest profile.

18. The recording medium of claim 16, wherein the determining the characteristic slope associated with the first interest profile further includes:

    normalizing a capacity-voltage domain of the first interest profile to match a reference capacity-voltage domain, thereby determining a second interest profile; and
    determining the characteristic slope to be equal to a slope of a tangent at a characteristic point of the second interest profile.

19. The recording medium of claim 18, wherein the determining the characteristic slope associated with the first interest profile further includes:

determining multiple comparison values respectively associated with multiple data points of the second interest profile; and
determining any one of the multiple data points associated with a minimum of the multiple comparison values as the characteristic point of the second interest profile.

FIG. 1

FIG. 2

FIG. 3

FIG. 4

FIG. 5

INTEREST CAPACITY RANGE

FIG. 6

FIG. 7

FIG. 8

FIG. 9

FIG. 10

FIG. 11

FIG. 12

FIG. 13

START

ACQUIRE CAPACITY-VOLTAGE RELATIONSHIP DATA OF BATTERY CELL ~S1310

GENERATING VOLTAGE PROFILE AND DIFFERENTIAL VOLTAGE PROFILE OF BATTERY ~S1320

EXTRACTING FIRST INTEREST PROFILE FROM VOLTAGE PROFILE BASED ON CHARACTERISTIC POINT OF DIFFERENTIAL VOLTAGE PROFILE ~S1330

DETERMINING CHARACTERISTIC SLOPE ASSOCIATED WITH FIRST INTEREST PROFILE ~S1340

DIAGNOSING DEGRADATION STATE OF BATTERY CELL BASED ON CHARACTERISTIC SLOPE ~S1350

DETERMINING AT LEAST ONE PROTECTION PARAMETER FOR BATTERY CELL ~S1360

CONTROLLING CHARGING/DISCHARGING OF BATTERY CELL BASED ON AT LEAST ONE PROTECTION PARAMETER ~S1370

END

FIG. 14

S1320                                    S1330

```
      ┌─────────────────────────────────────────────────┐
      │  ┌──────────────────────────────────────┐        │
      │  │ DETERMINING CHARACTERISTIC POINT FROM │~S1410  │
      │  │     DIFFERENTIAL VOLTAGE PROFILE      │        │
      │  └──────────────────────────────────────┘        │
      │                    │                             │
      │  ┌──────────────────────────────────────┐        │
      │  │ DETERMINING INTEREST CAPACITY RANGE BASED ON │~S1420
      │  │ CAPACITY VALUE OF CHARACTERISTIC POINT │      │
      │  └──────────────────────────────────────┘        │
      │                    │                             │
      │  ┌──────────────────────────────────────┐        │
      │  │ DETERMINING PORTION OF VOLTAGE PROFILE │      │
      │  │ CORRESPONDING TO INTEREST CAPACITY RANGE AS │~S1430
      │  │         FIRST INTEREST PROFILE        │        │
      │  └──────────────────────────────────────┘        │
      └─────────────────────────────────────────────────┘
```

S1340

FIG. 15

S1320                                    S1410

```
      ┌─────────────────────────────────────────────────┐
      │  ┌──────────────────────────────────────┐        │
      │  │ DETERMINING LOCAL MINIMUM POINT WITH MAXIMUM │ │
      │  │ DIFFERENTIAL VOLTAGE WITHIN TARGET CAPACITY │~S1510
      │  │ RANGE FROM DIFFERENTIAL VOLTAGE PROFILE │      │
      │  └──────────────────────────────────────┘        │
      │                    │                             │
      │  ┌──────────────────────────────────────┐        │
      │  │ DETERMINING LOCAL MINIMUM POINT LOCATED ON │   │
      │  │ HIGHER CAPACITY SIDE RELATIVE TO LOCAL │       │
      │  │ MAXIMUM POINT AS CHARACTERISTIC POINT OF │~S1520 │
      │  │      DIFFERENTIAL VOLTAGE PROFILE     │        │
      │  └──────────────────────────────────────┘        │
      └─────────────────────────────────────────────────┘
```

S1420

FIG. 16

S1330    S1340

NORMALIZING CAPACITY VOLTAGE DOMAIN OF FIRST
INTEREST PROFILE TO DETERMINE SECOND INTEREST PROFILE    ~S1610

DETERMINING CHARACTERISTIC POINT OF
SECOND INTEREST PROFILE    ~S1620

DETERMINING CHARACTERISTIC SLOPE THAT IS
IDENTICAL TO SLOPE OF TANGENT AT CHARACTERISTIC
POINT OF SECOND INTEREST PROFILE    ~S1630

S1350

FIG. 17

```
                    ┌─────────┐
                    │  START  │
                    └────┬────┘                              S1620
      ┌──────────────────┼──────────────────────────────────────┐
      │      ┌───────────▼────────────────┐                      │
      │      │ DIVIDING SECOND INTEREST PROFILE INTO A │         │
      │      │   FIRST SUB PROFILE AND SECOND          │         │
      │      │ SUB PROFILE BASED ON CAPACITY VALUE OF ├─ S1710    │
      │      │  iᵗʰ DATA POINT AMONG FIRST TO nᵗʰ DATA │         │
      │      │   POINTS OF SECOND INTEREST PROFILE     │         │
      │      └───────────┬────────────────┘                      │
```

DIVIDING SECOND INTEREST PROFILE INTO A FIRST SUB PROFILE AND SECOND SUB PROFILE BASED ON CAPACITY VALUE OF $i^{th}$ DATA POINT AMONG FIRST TO $n^{th}$ DATA POINTS OF SECOND INTEREST PROFILE ~S1710

DETERMINING AVERAGE VOLTAGE VALUE OF FIRST SUB PROFILE AND AVERAGE VOLTAGE VALUE OF SECOND SUB PROFILE ~S1720

S1730

DETERMINING FIRST ERROR VALUE OF FIRST SUB PROFILE BASED ON AVERAGE VOLTAGE VALUE OF FIRST SUB PROFILE

S1740

DETERMINING SECOND ERROR VALUE OF SECOND SUB PROFILE BASED ON AVERAGE VOLTAGE VALUE OF SECOND SUB PROFILE

DETERMINING $i^{th}$ COMPARISON VALUE TO BE EQUAL TO UM OF FIRST ERROR VALUE AND SECOND ERROR VALUE ~S1750

END

## INTERNATIONAL SEARCH REPORT

| | International application No. |
|---|---|
| | **PCT/KR2024/096347** |

### A. CLASSIFICATION OF SUBJECT MATTER

**G01R 31/392**(2019.01)i; **G01R 31/396**(2019.01)i; **G01R 31/382**(2019.01)i; **G01R 31/367**(2019.01)i; **G01R 31/36**(2006.01)i; **G01R 19/165**(2006.01)i; **G01R 19/00**(2006.01)i; **H01M 10/48**(2006.01)i

According to International Patent Classification (IPC) or to both national classification and IPC

### B. FIELDS SEARCHED

Minimum documentation searched (classification system followed by classification symbols)

G01R 31/392(2019.01); G01R 31/367(2019.01); G01R 31/382(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 전압(voltage), 프로파일(profile), 미분(differentiation)

### C. DOCUMENTS CONSIDERED TO BE RELEVANT

| Category* | Citation of document, with indication, where appropriate, of the relevant passages | Relevant to claim No. |
|---|---|---|
| Y | KR 10-2022-0021730 A (LG ENERGY SOLUTION, LTD.) 22 February 2022 (2022-02-22)<br>See paragraphs [0034]-[0103] and figures 1-5. | 1-19 |
| Y | KR 10-2022-0129944 A (RESEARCH & BUSINESS FOUNDATION SUNGKYUNKWAN UNIVERSITY) 26 September 2022 (2022-09-26)<br>See paragraph [0100] and claims 1-4. | 1-19 |
| Y | JP 2019-045351 A (MITSUBISHI MOTORS CORP.) 22 March 2019 (2019-03-22)<br>See paragraph [0030] and figure 2. | 2 |
| Y | KR 10-2022-0100470 A (LG ENERGY SOLUTION, LTD.) 15 July 2022 (2022-07-15)<br>See claim 16. | 7-8 |
| A | JP 2019-165553 A (MITSUBISHI MOTORS CORP.) 26 September 2019 (2019-09-26)<br>See claims 1-5. | 1-19 |

☐ Further documents are listed in the continuation of Box C.          ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **16 January 2025** | **16 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2024/096347**

| Patent document cited in search report | | | Publication date (day/month/year) | Patent family member(s) | | | Publication date (day/month/year) |
|---|---|---|---|---|---|---|---|
| KR | 10-2022-0021730 | A | 22 February 2022 | CN | 115413382 | A | 29 November 2022 |
| | | | | EP | 4131571 | A1 | 08 February 2023 |
| | | | | EP | 4131571 | A4 | 27 September 2023 |
| | | | | JP | 2023-517738 | A | 26 April 2023 |
| | | | | JP | 7372007 | B2 | 31 October 2023 |
| | | | | KR | 10-2596153 | B1 | 30 October 2023 |
| | | | | US | 11990590 | B2 | 21 May 2024 |
| | | | | US | 2023-0207910 | A1 | 29 June 2023 |
| | | | | US | 2024-0274902 | A1 | 15 August 2024 |
| | | | | WO | 2022-035032 | A1 | 17 February 2022 |
| KR | 10-2022-0129944 | A | 26 September 2022 | KR | 10-2634373 | B1 | 06 February 2024 |
| JP | 2019-045351 | A | 22 March 2019 | None | | | |
| KR | 10-2022-0100470 | A | 15 July 2022 | CN | 116724243 | A | 08 September 2023 |
| | | | | EP | 4235198 | A1 | 30 August 2023 |
| | | | | EP | 4235198 | A4 | 29 May 2024 |
| | | | | JP | 2024-500788 | A | 10 January 2024 |
| | | | | US | 2024-0027537 | A1 | 25 January 2024 |
| | | | | WO | 2022-149824 | A1 | 14 July 2022 |
| JP | 2019-165553 | A | 26 September 2019 | None | | | |

Form PCT/ISA/210 (patent family annex) (July 2022)

**EP 4 636 422 A1**

**Patent documents cited in the description**

- KR 1020230191785

- KR 1020240129279